# EUROPEAN PATENT SPECIFICATION

(11) **EP 1 526 406 B1**
(45) Date of publication and mention of the grant of the patent: **09.11.2011**
(21) Application number: 03705313.9
(22) Date of filing: 19.02.2003
(51) Int. Cl.: G03F 1/08, H01L 21/027

(54) **PHOTOMASK**
FOTOMASKE
MASQUE PHOTOGRAPHIQUE

(30) Priority: 31.07.2002 JP 2002223967
(43) Date of publication of application: 27.04.2005
(73) Proprietor: Fujitsu Semiconductor Limited, Kohoku-ku, Yokohama-shi Kanagawa 222-0033 (JP)
(72) Inventor: YAO, Teruyoshi, FUJITSU LIMITED, Kawasaki-shi, Kanagawa 211-8 588 (JP); ASAI, Satoru, FUJITSU LIMITED, Kawasaki-shi, Kanagawa 211-8588 (JP)
(74) Representative: Fenlon, Christine Lesley
(86) International application number: PCT/JP2003/001772
(87) International publication number: WO 2004/013695

(56) References cited:
- JP-A- 2000 124 305
- JP-A- 2000 195 787
- JP-A- 2001 125 252
- JP-A- 2001 125 252
- JP-A- 2001 272 766
- JP-A- 2002 189 279
- US-A- 5 948 573
- US-A- 5 948 573
- US-A1- 2002 142 233
- PATENT ABSTRACTS OF JAPAN vol. 2000, no. 10, 17 November 2000 (2000-11-17) & JP 2000 195787 A (HYUNDAI ELECTRONICS IND CO LTD), 14 July 2000 (2000-07-14)

## Description

### Technical Field

The present invention relates to a photomask used in a photolithography conducted when manufacturing a semiconductor device and so forth, a designing method of the same, and a semiconductor manufacturing method using the same.

### Background Art

When manufacturing a semiconductor device and so forth, a variety of patterns formed on a photomask are transferred to a photoresist formed on a substrate by photolithography. After the transferring, the photoresist is developed, and with the use of the patterns on the photoresist as a mask, a processing of a wiring layer or the like is conducted. In such a photolithography, a projecting exposure apparatus of a dioptric system or catadioptric system is used.

However, in such a lithography, an optical path different from a design is formed due to reflection, scattering, or variety of refraction indices of lens materials on a surface of or inside a lens of an illumination optical system, a mask, a projection lens, or so forth as a cause, generating a light via the optical path. Such a phenomenon is referred to a flare. When the flare is caused, the patterns transferred to the photoresist vary in feature and line width.

Therefore, conventionally, the flare has been addressed and reduced by approaches to coat the surface of the lens, to improve flatness of the surface of the lens, or the like.

However, in addition to the flare, recently, a phenomenon called "local flare" is viewed as a problem. The local flare is caused by aberration of an exposure apparatus. When the local flare is caused, similarly to the flare, variation in the line width or the like is caused. The local flare caused by one pattern in the mask affects in the range of about 50 µm from the pattern. Note that the affected range may vary depending on a generation or an exposure wave length both of the exposure apparatus, in the future. In addition, the local flare affects variously depending on an aperture area ratio in the vicinity of the pattern, so that the local flare affects differently depending on positions on the photomask. The aperture area ratio is the ratio of an area of a region which transmits light to the area thereof which does not transmit light. Accordingly, in the resist pattern, the line width varies at various levels depending on the position. It is therefore extremely difficult to modify the pattern on the photomask in view of the influence of the local flare.

Recently, the semiconductor device is increasingly improved in miniaturization and integration, and along with such improvements, reduction in wavelength is in progress for the exposure light used in the projecting exposure apparatus. Specifically, an exposure light of a wavelength of 193 nm is in use, whereas, due to specificity of the lens when responding to such a wavelength, light coverage differs in accordance with an opening area in the vicinity of one pattern, in which a flare caused locally depending on an exposure pattern is gradually regarded as a problem. Such a flare is called "local flare", and causes, as a main cause, a contingent variation in the feature or the line width of the pattern transferred. The previously-described aberration of the exposure apparatus is due to the specificity of the lens material.

US-A-5948573 discloses a method of designing a photomask for use in exposing a photosensitive body on a substrate, said designing method comprising the steps of: determining a main pattern which is to be transferred to said photosensitive body, based on a circuitry of a semiconductor device to be manufactured; and determining a plurality of sub-patterns which may be selected for transfer to said photosensitive body.

### Summary of the Invention

The present invention has been made in consideration of the above-described problem, and an object thereof is to provide a photomask capable of restraining a difference in variation amount of a line width caused by a local flare, a designing method of the same, and a semiconductor device manufacturing method using the same.

After due diligent efforts to bring a solution to the problem, the present inventors have devised embodiments as will be described below.

According to a first aspect of the present invention there is provided a photomask for use in exposing a photosensitive body on a substrate, the photomask comprising: a main pattern which is to be transferred to the said photosensitive body; and a plurality of sub-patterns, wherein the size of the sub-patterns is smaller than a minimum size transferable to said photosensitive body by exposure; **characterized in that**, when an irradiation region of the photomask, over which exposure light is to be irradiated, is sectioned into a plurality of virtual regions having a uniform size, aperture area ratios of said plurality of virtual regions, which aperture area ratio is defined as the ratio of the area of a virtual region which transmits light to the area thereof which does not transmit light, are uniform.

According to a second aspect of the present invention there is provided a method of designing a photomask for use in exposing a photosensitive body on a substrate, said designing method comprising the steps of: determining a main pattern which is to be transferred to said photosensitive body, based on a circuitry of a semiconductor device to be manufactured; and determining a plurality of sub-patterns which may be selected for transfer to said photosensitive body, which sub-patterns have a size smaller than a minimum size transferable to said photosensitive body by exposure; characterised by sectioning an irradiation region of the photomask, over which exposure light is to be irradiated, into a plurality of virtual regions having a uniform size and calculating aperture area ratios for the patterns determined at that time for each of said plurality of virtual regions, which aperture area ratio is defined as the ratio of the area of a virtual region which transmits light to the area thereof which does not transmit light; wherein, in said step of determining a plurality of sub-patterns, the aperture area ratios of the said plurality of virtual regions are made uniform.

According to these embodiments of the present invention, an influence of a local flare comes to be substantially uniform over an entire photomask, so that variations in line width or the like of patterns formed on a photosensitive body by a transfer come to be uniform in similar fashion. Such a uniform variation in size allows modification with ease for example by adjusting output energy of an exposure apparatus or the like, so that a desired pattern can be transferred to a photosensitive body easily.

According to a third aspect of the present invention there is provided a semiconductor device manufacturing method comprising the step of exposing a photosensitive body formed on a layer to be processed using a photomask according to the first or second aspect of the present invention.

### Brief Description of the Drawings

Fig. 1 is a schematic view showing a positional relationship on a photomask among a region A, a region B, and a region C;
Fig. 2A to Fig. 2C are schematic views showing a quantifying method of a local flare;
Fig. 3 is a graphic chart obtained from the method shown in Fig. 2A to Fig. 2C;
Fig. 4 is a schematic view showing a fundamental principle of the present invention;
Fig. 5A to Fig. 5D are schematic views showing a photomask according to a first example which does not embody the present invention;
Fig. 6A to Fig. 6D are schematic views showing a photomask according to a first embodiment of the present invention;
Fig. 7A to Fig. 7D are schematic views showing a photomask according to a second embodiment of the present invention;
Fig. 8A to Fig. 8D are schematic views showing a photomask according to a third embodiment of the present invention; and
Fig. 9A to Fig. 9D are schematic views showing a photomask reversing positive/negative types of the first example.

### Detailed Description of the Preferred Embodiments

### - Basic Gist of the Present invention -

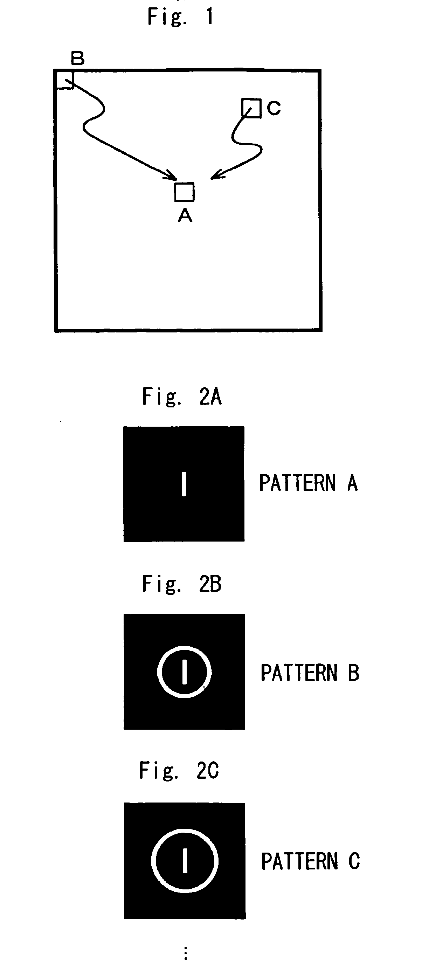

First, a basic gist of the present invention will be described with reference to the attached drawings. Fig. 1 is a schematic view showing a positional relationship on a photomask among a region A, a region B, and a region C.

In Fig. 1, it is assumed that an arbitrary region A and arbitrary regions B and C be distant from each other within a range of about 20µm. When a light is applied to such a photomask, a flare caused by the light transmitting the regions B and C affects a pattern to be formed on a photosensitive body (body to be transferred) such as a photoresist by a transfer of a pattern formed on the region A. As a result, when a line pattern is formed in the region A, a line width thereof varies.

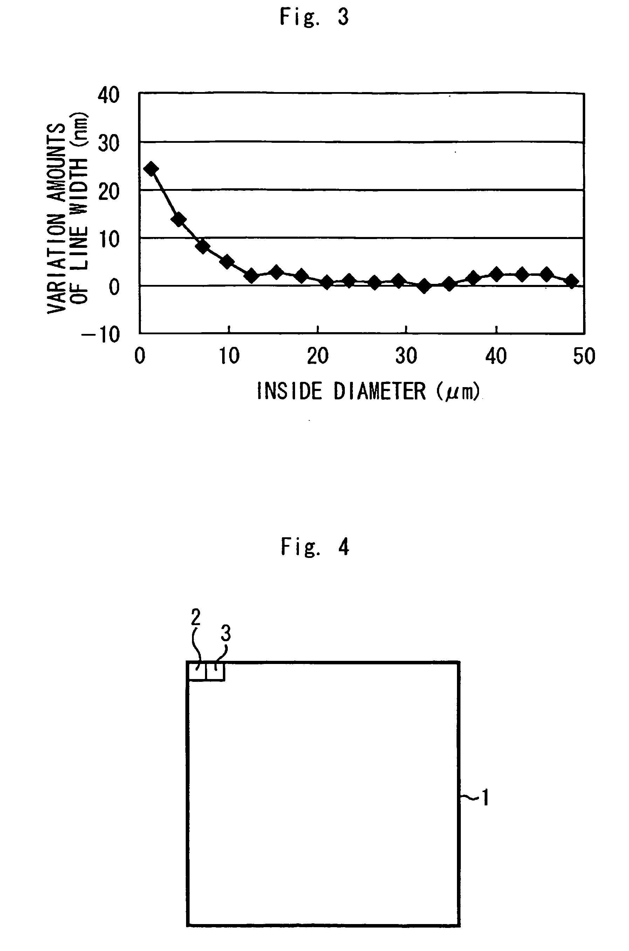

Here, a relation between a distance between a pattern affected by a local flare and a pattern affecting and an affecting level of the local flare will be described. As to the relation, the present inventors have found that the affecting level of the local flare increases as the distance between the two patterns is shortened. Fig. 2A to Fig. 2C are schematic views showing a quantifying method of the local flare, and Fig. 3 is a graphic chart obtained from the method shown in Fig. 2A to Fig. 2C. Note that, in Fig. 2A to Fig. 2C, a light-shielding region is indicated by being blacked out, and a remaining region is a transmissive region. This is also applicable to the drawings showing the other mask patterns.

In this method, first, with the use of a transmissive line pattern having a width of 0.12 µm as shown in Fig. 2A as a reference, the line width of a pattern formed on the photosensitive body by the transfer of the reference was measured. Subsequently, with the use of a mask provided with a transmissive pattern of an orbicular zone shape around the reference as shown in Fig. 2B, an exposure was performed to measure the line width of a line pattern formed on the photosensitive body. At that time, an inside diameter of a circle was 4.14 µm, and a width of the circle was 2.76 µm. Subsequently, as shown in Fig. 2C, the measurement was similarly made to the line width by varying the inside diameter of the transmissive pattern of the orbicular zone shape while keeping the width of the circle to be constant. At that time, the inside diameter of the circle was 6.89 µm, and the width of the circle was 2.76 µm. Then, the measurements were made for the line width sequentially by varying the inside diameter of the transmissive pattern of the orbicular zone shape while keeping the width of the circle to be constant. Then, variation amounts of respective line widths were plotted in comparison with the line width of the line pattern formed by conducting the exposure using the mask provided with the reference only. Fig. 3 shows the result.

Incidentally, in the exposure, a scanning type exposure apparatus using ArF excimer laser as a light source was used under an illumination condition: numerical aperture NA = 0.70 and 1/2 zone (sigmaout = 0.85).

As a result of the above-described quantification, as shown in Fig. 3, a marked increase in the line width arose in an inside diameter range of around 15 µm or below. This indicates that the reference was largely affected by a local flare caused by the pattern distant therefrom at an interval of around 15 µm. Besides, the influence of the local flare came to be larger as the pattern comes close to the reference.

In the present invention, when an irradiation region of a photomask to which at least exposure light is to be applied is sectioned into a plurality of virtual regions having a certain feature size, aperture area ratios over the plural virtual regions are substantially uniform. What is meant here by "aperture area ratios are substantially uniform" is, although the complete uniformity of the aperture area ratios is preferable, there is sometimes a case where the aperture area ratios cannot be completely uniform due to a constraint on the photomask designing even if a sub-pattern is provided, and the case is also included therein. For instance, the sub-pattern may be formed on the photomask in addition to the main pattern so that those virtual regions exhibiting a lower aggregate aperture area ratio, including every pattern therein except the sub-pattern, have a lesser amount of reduction in the aperture area ratio due to the formation of the sub-patterns. The aggregate aperture area ratio is the ratio of the total area of the virtual region which transmits light to that which shields light, where there is more than one pattern in the virtual region.

For instance, as shown in Fig. 4, assuming that an irradiation region 1 in the photomask is sectioned into virtual regions of a square each having a side of 2 µm and in the comparison between a virtual region 2 and a virtual region 3 in the drawing, if the aggregate aperture area ratio, including every pattern therein except the sub-pattern, in the virtual region 2 is lower than that in the virtual region 3, the reduction amount in the aperture area ratio caused by the formation of the sub-pattern in the virtual region 2 is higher than the reduction amount in the aperture area ratio caused by the formation of the sub-pattern in the virtual region 3. On the other hand, when the aggregate aperture area ratio, including every pattern therein except the sub-pattern in the virtual region 3 is lower than that in the virtual region 2, the reduction amount in the aperture area ratio caused by the formation of the sub-pattern in the virtual region 2 is lower than the reduction amount in the aperture area ratio caused by the formation of the sub-pattern in the virtual region 3. Also, for all of the remaining virtual regions in the irradiation region 1, the reduction amounts in the aperture area ratios caused by the formation of the sub-pattern are set as described above, even though it is not shown in Fig. 4. Preferably, the aperture area ratios for all of the virtual regions in the irradiation region 1 are uniform.

Here, "an amount of reduction in an aperture area ratio" is not an absolute value, and, when the aperture area ratio increases caused by the formation of the sub-pattern, a negative value is adopted. Then, the comparison of the reduction amounts is conducted using the negative values as they are.

### (First Example)

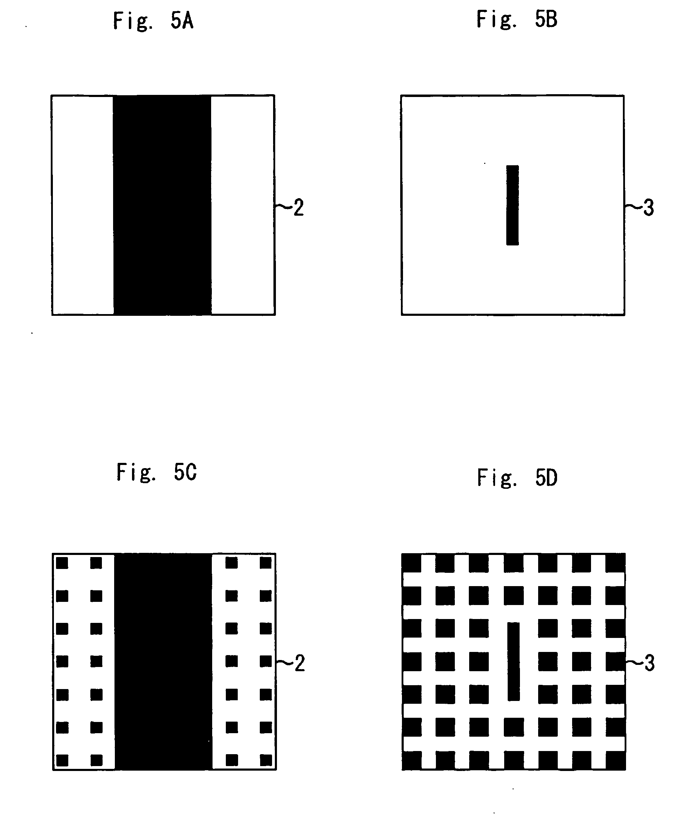

First, a first example which does not embody the present invention will be described. Fig. 5A to Fig. 5D are schematic views showing a photomask, Fig. 5A showing a main pattern in the virtual region 2 in Fig. 4 and Fig. 5B showing a main pattern in the virtual region 3 in Fig. 4. Fig. 5C shows the main pattern and a sub-pattern (dummy pattern) in the virtual region 2 and Fig. 5D shows the main pattern and a sub-pattern (dummy pattern) in the virtual region 3. These main patterns and sub-patterns are light-shielding patterns.

In the present example, as shown in Fig. 5A and Fig. 5B, if there were formed only the main pattern in each of the virtual regions 2 and 3, the aperture area ratios would be 60% and 90%, respectively. Conventional photomasks are used in these states. In the present example, as shown in Fig. 5C and Fig. 5D, dummy patterns are formed to serve as the sub-patterns in the virtual regions 2 and 3. The dummy patterns in the virtual region 2 are square-shaped light shielding patterns each having a side of 0.15 µm, and the dummy patterns in the virtual region 3 are square-shaped light shielding patterns each having a side of 0.2 µm. The pitches (center distances) of these dummy patterns are uniform in the virtual regions 2 and 3. The aperture area ratios for the virtual regions 2 and 3 are both set to 30%

Similarly, in all the other virtual regions, dummy patterns of an appropriate size are formed at uniform pitches and the aperture area ratios for the respective virtual regions are set to 30%, even though it is not shown in Fig. 5A to Fig. 5D.

In table 1 shown below, "aggregate aperture area ratios for every pattern except sub-patterns" and "amount of reduction in aperture area ratios caused by formation of sub-patterns" in respective virtual regions are organized and presented.

Here, positions on which the dummy patterns are formed are those positions not affecting an operation of a semiconductor device over an allowable range even if they are transferred to a photosensitive body. In other words, the dummy patterns are formed outside a so-called design data prohibition region (design data prohibition zone). Therefore, a dummy pattern is in no case formed at such a position that causes a short circuit of a wiring or a significant increase in parasitic capacitance.

If an exposure is conducted using the thus-structured photomask according to the first example, in any point in the range of the photosensitive body where exposure light is applied, amounts of light caused by a local flare come to be substantially uniform. As a result, variations in line widths, even if caused, come to be uniform in level over the photomask.

Incidentally, in the first example, the sizes of the dummy patterns are adjusted while fixing the pitches of the dummy patterns to a certain pitch, whereas the aperture area ratios over the virtual regions may be made uniform by adjusting the pitches of the dummy patterns while fixing the sizes of the dummy patterns to a certain size. Specifically, the sub-patterns can be formed more sparsely as the aperture area ratio for the main pattern decreases. Alternatively, the aperture area ratios over the virtual regions may be made uniform by adjusting both the pitches and sizes. In other words, the sub-patterns may be formed in a smaller size and more sparsely as the aperture area ratio for the main pattern decreases.

### (First Embodiment)

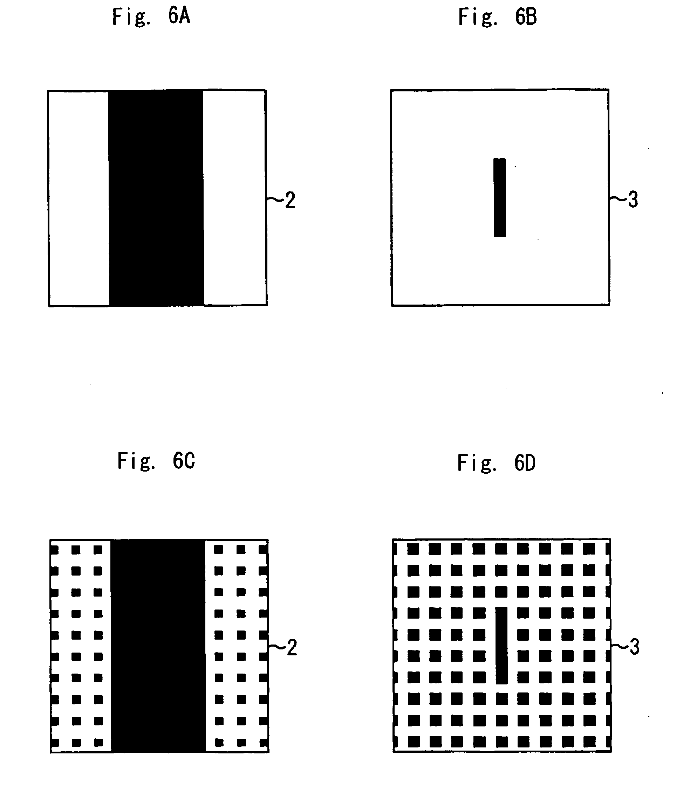

Next, a first embodiment according to the present invention will be described. Fig. 6A to Fig. 6D are schematic views showing a photomask according to the first embodiment of the present invention. Fig. 6A shows a main pattern in the virtual region 2 in Fig. 4, and Fig. 6B shows a main pattern in the virtual region 3 in Fig. 4. Further, Fig. 6C shows the main pattern and a sub-pattern (dummy pattern) in the virtual region 2, and Fig. 6D shows the main pattern and a sub-pattern (dummy pattern) in the virtual region 3. These main patterns and sub-patterns are light-shielding patterns.

Also, in the present embodiment, as shown in Fig. 6A and Fig. 6B, if there were formed only a main pattern in each of the virtual regions 2 and 3, their aperture area ratio would be 60% and 90%, respectively. In the present embodiment, further, as shown in Fig. 6C and Fig. 6D, the dummy patterns are formed in the virtual regions 2 and 3 to serve as the sub-patterns. The dummy patterns in the virtual region 2 are square light shielding patterns each having a side of 0.05 µm, and the dummy patterns in the virtual region 3 are square light shielding patterns each having a side of 0.08 µm. The sizes of these dummy patterns are below a resolution limit, so that these dummy patterns are not transferred by exposure. The pitches (center distances) of these dummy patterns are uniform in the virtual regions 2 and 3. The aperture area ratios for the virtual regions 2 and 3 are both set to 30%.

Similarly, in all other virtual regions, dummy patterns of an appropriate size are formed at uniform pitches and the aperture area ratios for the respective virtual regions are set to 30%, even though it is not shown in Fig. 6A to Fig. 6D.

In table 2 shown below, "aggregate aperture area ratios for every pattern except sub-patterns" and "amount of reduction in aperture area ratios caused by formation of sub-patterns" in respective virtual regions are organized and presented.

If an exposure is conducted using the thus-structured photomask according to the first embodiment, in any point in the range of the photosensitive body where exposure light is applied, amounts of light caused by a local flare come to be substantially uniform. As a result, variations in line widths, even if caused, come to be uniform in level over the photomask.

Further, in the first embodiment, the respective dummy patterns have sizes smaller than the minimum size of a transferable dummy pattern, so that, differently from the first example, the dummy pattern can be provided even at such a position in a photosensitive body that allows no pattern to be provided.

Incidentally, also in the first embodiment, the sizes of the dummy patterns are adjusted while fixing the pitches of the dummy patterns to a certain pitch, whereas the aperture area ratios over the virtual regions may be made uniform by adjusting the pitches of the dummy patterns while fixing the sizes of the dummy patterns to a certain size. Specifically, the sub-patterns can be formed more sparsely as the aperture area ratio for the main pattern decreases. Alternatively, the aperture area ratios over the virtual regions may be made uniform by adjusting both the pitches and sizes. In other words, the sub-patterns may be formed in a smaller size and more sparsely as the aperture area ratio for the main pattern decreases.

### (Second Embodiment)

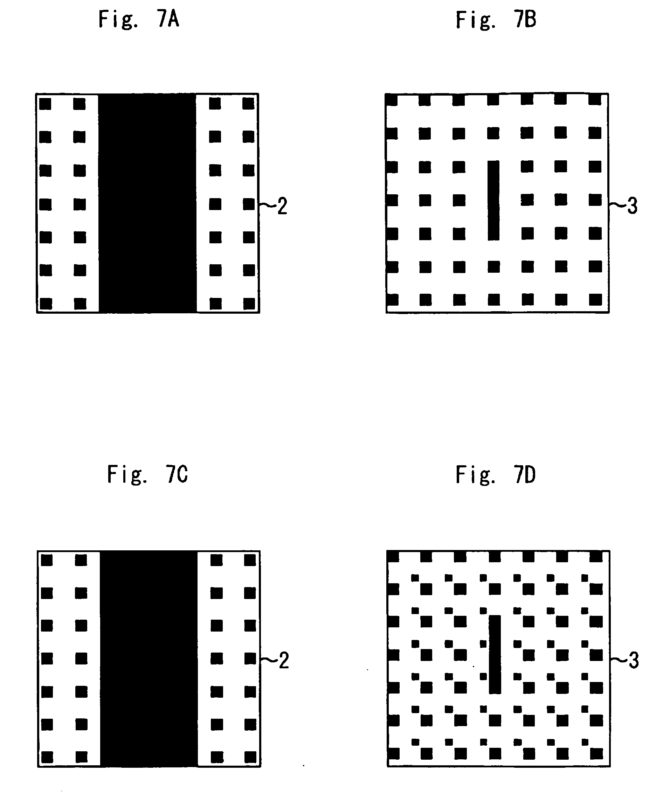

Subsequently, a second embodiment according to the present invention will be described. Fig. 7A to Fig. 7D are schematic views showing a photomask according to the second embodiment of the present invention. Fig. 7A shows a main pattern and a pattern for polishing in the virtual region 2 in Fig. 4, and Fig.7B shows a main pattern and a pattern for polishing in the virtual region 3 in Fig. 4. Further, Fig. 7C shows the main pattern patterns, the pattern for polishing and a sub-pattern (dummy pattern) in the virtual region 2, and Fig. 7D shows the main pattern, the pattern for polishing, and a sub-pattern (dummy pattern) in the virtual region 3. These main patterns, patterns for polishing, and sub-patterns are light-shielding patterns.

Here, description will be provided for a pattern for polishing. The pattern for polishing has been conventionally formed on the photomask when it is appropriate. In manufacturing a semiconductor device, there may be a case where an etching of a wiring layer, insulating layer or the like on a semiconductor substrate is conducted using a photoresist having a pattern formed thereon as a mask, and thereafter the other materials are filled into a groove or the like formed by the etching, and a planarization process is performed by CMP (Chemical Mechanical Polishing). At that time, if the etched layer in the wafer has large differences in its crude density (i.e. the density of the material forming the etched layer, which has an effect on the polishing rate), the polishing amount may vary greatly according to the differences in crude density. Therefore, with the intent to decrease the differences in crude density, sometimes, the patterns for polishing may be provided to have an adequate density on the photomask.

Therefore, in the present embodiment, as shown in Fig. 7A and Fig. 7B, the main pattern and the pattern for polishing are formed on both the virtual regions 2 and 3, and, if there were formed only the main pattern and the pattern for polishing in each of the virtual regions 2 and 3, the aperture area ratios would be 30% and 50%, respectively. In the present embodiment, besides, as shown in Fig. 7D, the dummy patterns are also formed on the virtual region 3 to serve as the sub-patterns. The dummy patterns are square light-shielding patterns each having a side of 0.08 µm. The sizes of these dummy patterns are below the resolution limit, so that the patterns are not transferred to the photosensitive body even if exposed. The aperture area ratio for the virtual regions 3 is set to 30%. Meanwhile, as shown in Fig. 7C, there is formed no dummy pattern in the virtual region 2, and the aperture area ratio stays at 30%.

Further, even though it is not shown in Fig. 7A to Fig. 7D, similarly, in all the other virtual regions, if the aperture area ratio is over 30% in the state of having only the main pattern and the pattern for polishing, the dummy pattern of an appropriate size below the resolution limit are formed, and the aperture area ratios in the respective regions are set to 30%.

In table 3 shown below, "aggregate aperture area ratios for every pattern except sub-patterns" and "amount of reduction in aperture area ratios caused by formation of sub-patterns" in respective virtual regions are organized and presented.

If an exposure is conducted using the thus-structured photomask according to the second embodiment, in any point in the range of the photosensitive body where exposure light is applied, amounts of light caused by a local flare come to be substantially uniform. As a result, variations in line widths, even if caused, come to be uniform in level over the photomask.

Further, in the second embodiment, the respective dummy patterns have sizes smaller than the minimum size of a transferable dummy pattern, so that a dummy pattern can be provided even at a position in the photosensitive body where no pattern is allowed to be provided.

### (Third Embodiment)

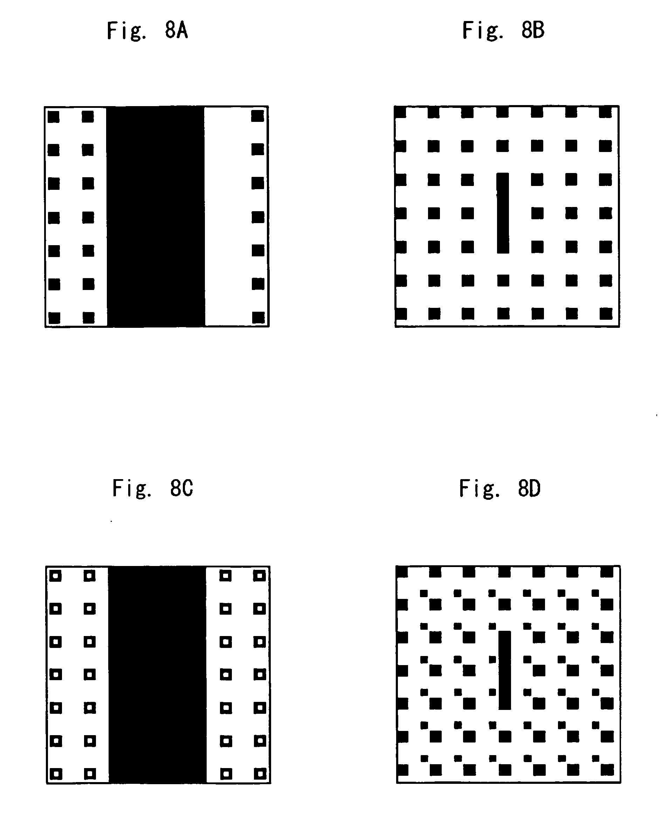

Subsequently, a third embodiment according to the present invention will be described. Fig. 8A to Fig. 8D are schematic views showing a photomask according to the third embodiment of the present invention.

Fig. 8A shows a main pattern and a pattern for polishing in the virtual region 2 in Fig. 4, and Fig. 8B shows a main pattern and a pattern for polishing in the virtual region 3 in Fig. 4. Further, Fig. 8C shows the main pattern, the pattern for polishing and a sub-pattern (dummy pattern) in the virtual region 2, and Fig. 8D shows the main pattern, the pattern for polishing and a sub-pattern (dummy pattern) in the virtual region 3. These main patterns and patterns for polishing are light-shielding patterns, while the sub-patterns include a transmissive pattern in addition to the light-shielding pattern, as will be described herein below.

In the present embodiment, as shown in Fig. 8A and Fig. 8B, the main pattern and pattern for polishing are formed on both the virtual regions 2 and 3, and, if there were formed only the main pattern and the pattern for polishing in each of the virtual regions 2 and 3, the aperture area ratios would be 20% and 50%, respectively. In the present embodiment, further, as shown in Fig. 8C, the dummy patterns made of transmissive patterns are formed to serve as the sub-patterns in the virtual region 2. The sizes of these dummy patterns in the virtual region 2 are below a resolution limit, and formed as a hole pattern in the patterns for polishing. Further, as shown in Fig. 8D, dummy patterns are formed in the virtual region 3 to serve as sub-patterns. The respective dummy patterns in the virtual region 3 are square light-shielding patterns each having a side of 0.08 µm. The sizes of these dummy patterns are below the resolution limit, so that the patterns are not transferred to the photosensitive body by exposure. The aperture area ratios for the virtual regions 2 and 3 are set to both 30%.

Further, even though it is not shown in Fig. 8A to Fig. 8D, also in all the other virtual regions, if the aperture area ratio is over 30% in the state of having only the main pattern and the patterns for polishing, the dummy patterns in an appropriate size below the resolution limit and made of the light-shielding patterns are formed, and if the aperture area ratio is below 20% in the state of having only the main pattern and the patterns for polishing, the dummy patterns in an appropriate size below the resolution limit and made of the transmissive patterns are formed in the patterns for polishing. Hence, the aperture area ratios are set to 30% in all the regions.

In table 4 shown below, "aggregate aperture area ratios for every pattern except sub-patterns" and "amount of reduction in aperture area ratios caused by formation of sub-patterns" in respective virtual regions are organized and presented.

If an exposure is conducted using the thus-structured photomask according to the third embodiment, in any point in the range of a photosensitive body where an exposure light is applied, amounts of light caused by a local flare come to be substantially uniform. As a result, the variations in line widths, even if caused, come to be uniform in level over the photomask.

According to these embodiments, variations in line width due to an influence by a local flare come to be uniform over the entire photomask. The line width can be increased or decreased with ease for example by adjusting output energy of an exposure apparatus, and so forth. Accordingly, a resist pattern of a desired line width can be obtained with ease without an effort of modifying an intricate pattern on the photomask.

It should be noted that the aperture area ratios are assumed to be uniform over the entire virtual regions in these embodiments, whereas, the present invention is not limited thereto. Specifically, even if the aperture area ratios are not uniform, it is also within the scope of the present invention that those virtual regions exhibiting a lower aggregate aperture area ratio for every pattern except the sub-pattern have a lesser amount of reduction in the aperture area ratio due to the formation of the sub-patterns.

The upper limit of the size of the virtual region can be determined based on the range that the local flare affects, and an affecting level. For instance, if a graph shown in Fig. 3 is obtained, it is considered that the influential range of the local flare is within a circle with radius about 20 µm. Meanwhile, as to the lower limit of the size of the virtual region, theoretically, the influence of the local flare comes to be uniform as the virtual region becomes smaller, however, if the virtual region is excessively small, there may be a case where the main pattern exists all over the region, leaving no room to provide a sub-pattern. Further, the load on a computer increases as the virtual region becomes small. Accordingly, under a current design rule, the feature of the virtual region is preferably a rectangle having sides from 0.5 µm to 5 µm, in particular, a rectangle having sides from 2 µm to 5 µm.

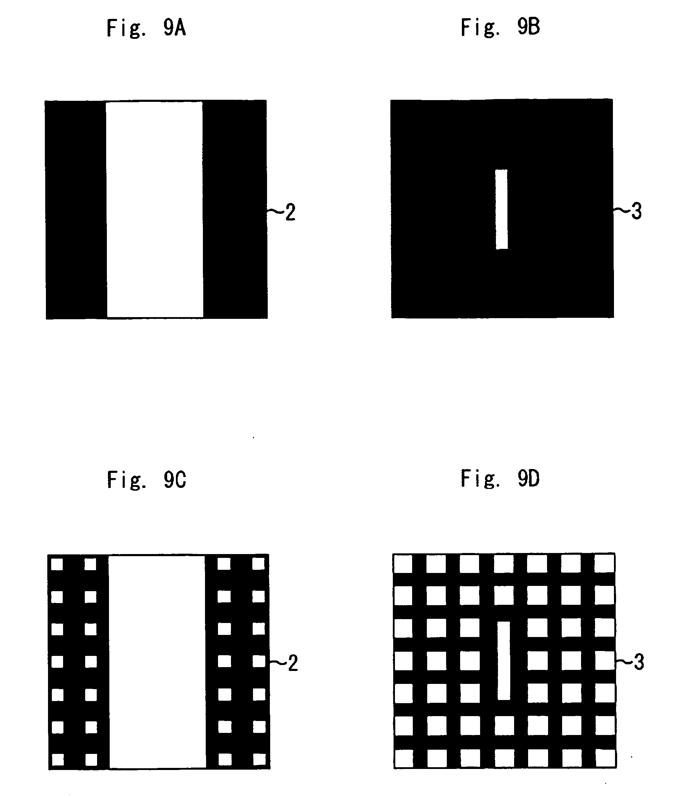

Moreover, in the first to third embodiments, a main pattern (and patterns for polishing) is (are) formed as light-shielding pattern(s), whereas, the present invention is also applicable to a photomask in which the main pattern (and the patterns for polishing) is (are) formed as transmissive pattern(s). Fig. 9A to Fig. 9D are schematic views showing a photomask having positive/negative types opposite to the photomask according to the first example. Also, in this case, sub-patterns are formed such that those virtual regions exhibiting a lower aggregate aperture area ratio for every pattern except the sub-pattern have a lesser amount of reduction in the aperture area ratio due to the formation of the sub-patterns.

In table 5 shown below, "aggregate aperture area ratios for every pattern except sub-patterns" and "amount of reduction in aperture area ratios caused by formation of sub-patterns" are organized and presented in respective virtual regions.

As shown in Table 5, in the examples shown in Fig. 9A to Fig. 9D, the aggregate aperture area ratios of the virtual region 3 for all patterns except sub-patterns (10%) are lower than those of the virtual region 2 (40%), so that the amount of reduction (-60%) in the aperture area ratio of the virtual region 3 due to the formation of the sub-patterns is lower than that (-30%) of the virtual region 2.

Subsequently, when designing the aforementioned photomask, a main pattern is determined based on a circuitry, at first. At this time, the designing of patterns for polishing may be made together as in the cases of the second and third embodiments. Subsequently, the entire irradiation region is sectioned into virtual regions, and the aggregate aperture area ratio for a main pattern (and patterns for polishing), namely the aggregate aperture area ratio for all patterns except sub-patterns is obtained for each virtual region. Next, the feature (size) and positions (pitch) of the sub-patterns in the photomask as previously described are determined so that those virtual regions exhibiting a lower aggregate aperture area ratio for every pattern except the sub-pattern have a lesser amount of reduction in the aperture area ratio due to the formation of the sub-patterns. The sub-pattern may be provided in the pattern for polishing as in the case of the third embodiment. Thus, the patterns for the respective virtual regions are designed to complete the overall designing of the photomask.

Furthermore, what to do when manufacturing a semiconductor device using the aforementioned photomask is, to form a photoresist by a coating or the like beforehand to thereby expose the photoresist using the photomask, to develop the photoresist thereafter, and to process a layer to be processed using the patterned photoresist as a mask.

### Industrial Applicability

As has been described in the above, according to the present invention, in any point in the range of a photosensitive body where an exposure light is applied, amounts of light caused by a local flare is enabled to be substantially uniform. As a result, the variations in line width, even if caused, come to uniform in level over the photomask. Increase or decrease of a line width can be made with ease, for example, by adjusting output energy of an exposure apparatus or the like. Accordingly, a resist pattern of a desired line width can be obtained with ease without an effort of modifying a pattern of an intricate photomask.

**Table 1**

| | Virtual region 2 | Virtual region 3 |
|---|---|---|
| Aggregate aperture area ratio for every pattern except sub-patterns | 60% | 90% |
| Amount of reduction in aperture area ratios caused by formation of sub-patterns | 30% | 60% |

**Table 2**

| | Virtual region 2 | Virtual region 3 |
|---|---|---|
| Aggregate aperture area ratio for every pattern except sub-patterns | 60% | 90% |
| Amount of reduction in aperture area ratios caused by formation of sub-patterns | 30% | 60% |

**Table 3**

| | Virtual region 2 | Virtual region 3 |
|---|---|---|
| Aggregate aperture area ratio for every pattern except sub-patterns | 30% | 50% |
| Amount of reduction in aperture area ratios caused by formation of sub-patterns | 0% | 20% |

**Table 4**

| | Virtual region 2 | Virtual region 3 |
|---|---|---|
| Aggregate aperture area ratio for every pattern except sub-patterns | 20% | 50% |
| Amount of reduction in aperture area ratios caused by formation of sub-patterns | -10% | 20% |

**Table 5**

| | Virtual region 2 | Virtual region 3 |
|---|---|---|
| Aggregate aperture area ratio for every pattern except sub-patterns | 40% | 10% |
| Amount of reduction in aperture area ratios caused by formation of sub-patterns | -30% | -60% |

## Claims

1. A photomask for use in exposing a photosensitive body on a substrate, the photomask comprising:
a main pattern which is to be transferred to the said photosensitive body; and
a plurality of sub-patterns, wherein the size of the sub-patterns is smaller than a minimum size transferable to said photosensitive body by exposure;
**characterized in that**, when an irradiation region (1) of the photomask, over which exposure light is to be irradiated, is sectioned into a plurality of virtual regions (2, 3) having a uniform size, aperture area ratios of said plurality of virtual regions, which aperture area ratio is defined as the ratio of the area of a virtual region which transmits light to the area thereof which does not transmit light, are uniform.

2. The photomask according to claim 1, wherein if a virtual region (2, 3) exhibits an aggregate aperture area ratio, including every pattern therein except said sub-pattern, which is lower than that of another virtual region (2, 3), the reduction in aperture area ratio caused by the formation of said sub-pattern in the said one virtual region (2, 3) is lower than the reduction in aperture area ratio caused by the formation of said sub-pattern in the said another virtual region (2, 3).

3. The photomask according to claim 1 or 2,
wherein pitches of said sub-patterns are substantially uniform and those virtual regions (2, 3) exhibiting a lower aggregate aperture area ratio, including every pattern therein except said sub-pattern, have sub-patterns which are smaller in size over the plurality of virtual regions (2, 3).

4. The photomask according to claim 1 or 2,
wherein the sizes of said sub-patterns are substantially uniform and those virtual regions (2, 3) exhibiting a lower aggregate aperture area ratio, including every pattern therein except said sub-pattern, have sub-patterns which are formed more sparsely over the plurality of virtual regions (2, 3).

5. The photomask according to claim 1 or 2,
wherein those virtual regions (2, 3) exhibiting a lower aggregate aperture area ratio, including every pattern therein except said sub-patterns, have sub-patterns which are smaller in size and formed more sparsely over the plurality of virtual regions (2, 3).

6. The photomask according to claim 1 or 2,
wherein said virtual region (2, 3) is a region of a rectangle having respective sides of 0.5 µm to 5 µm.

7. The photomask according to claim 1 or 2,
wherein a pattern for polishing is formed, said pattern for polishing being larger than a minimum size transferable to said photosensitive body by exposure and being in an allowable range of affecting an operation of said semiconductor device when said pattern for polishing is transferred to said photosensitive body.

8. The photomask according to claim 7, wherein,
said sub-pattern and said pattern for polishing are of either a positive type or a negative type being different from each other, and
said sub-pattern is formed inside said pattern for polishing.

9. A method of designing a photomask for use in exposing a photosensitive body on a substrate, said designing method comprising the steps of:
determining a main pattern which is to be transferred to said photosensitive body, based on a circuitry of a semiconductor device to be manufactured; and
determining a plurality of sub-patterns which may be selected for transfer to said photosensitive body, which sub-patterns have a size smaller than a minimum size transferable to said photosensitive body by exposure;
**characterised by** sectioning an irradiation region of the photomask, over which exposure light is to be irradiated, into a plurality of virtual regions (2, 3) having a uniform size and calculating aperture area ratios for the patterns determined at that time for each of said plurality of virtual regions (2, 3), which aperture area ratio is defined as the ratio of the area of a virtual region which transmits light to the area thereof which does not transmit light;
wherein, in said step of determining a plurality of sub-patterns, the aperture area ratios of the said plurality of virtual regions (2, 3) are made uniform.

10. The method according to claim 9, wherein in said step of determining a plurality of sub-patterns, one of the said virtual regions (2, 3) exhibiting an aggregate aperture area ratio, including every pattern therein except said sub-pattern, which is lower than that of another virtual region (2, 3) is made such that the reduction in aperture area ratio caused by the formation of said sub-pattern in the said one virtual region (2, 3) is lower than the reduction in aperture area ratio caused by the formation of said sub-pattern in the said another virtual region (2, 3).

11. The method according to claim 9 or 10, wherein, in said step of determining a plurality of sub-patterns, pitches of said sub-patterns of the plurality of virtual regions (2, 3) are substantially uniform, and those virtual regions (2, 3) exhibiting a lower aggregate aperture area ratio, including every pattern therein except said sub-pattern, have sub-patterns smaller in size.

12. The method according to claim 9 or 10, wherein, in said step of determining a plurality of sub-patterns, sizes of said sub-patterns of the plurality of virtual regions (2, 3) are substantially uniform, and those virtual regions (2, 3) exhibiting a lower aggregate aperture area ratio, including every pattern therein except said sub-pattern, have sub-patterns arranged more sparsely.

13. The method according to claim 9 or 10, wherein, in said step of determining a plurality of sub-patterns, those virtual regions (2, 3) exhibiting a lower aggregate aperture area ratio, including every pattern therein except said sub-pattern, have sub-patterns smaller in size and arranged more sparsely.

14. The method according to claim 9 or 10, wherein, in said step of determining a plurality of sub-patterns, said virtual region (2, 3) is made to be a rectangle having respective sides of 0.5 µm to 5 µm.

15. The method according to claim 9 or 10, further comprising the step of determining a pattern for polishing, before said step of calculating the aggregate aperture area ratio, said pattern for polishing being larger than a minimum size transferable to said photosensitive body by exposure and being in an allowable range of affecting an operation of said semiconductor device when said pattern is transferred to said photosensitive body.

16. The method according to claim 9 or 10, wherein
said sub-pattern and said pattern for polishing are of either a positive type or a negative type being different from each other, and
said sub-pattern is formed inside said pattern for polishing.

17. A semiconductor device manufacturing method comprising the step of exposing a photosensitive body formed on a layer to be processed using a photomask according to claim 1 or 2.

## Patentansprüche

1. Photomaske zur Verwendung beim Belichten eines lichtempfindlichen Körpers auf einem Substrat, welche Photomaske umfasst:
ein Hauptmuster, das aus den lichtempfindlichen Körper zu übertragen ist; und
eine Vielzahl von Untermustern, wobei die Größe der Untermuster kleiner als eine minimale Größe ist, die auf den lichtempfindlichen Körper durch Belichtung übertragbar isL;
**dadurch gekennzeichnet, dass** dann, wenn eine Einstrahlungsregion (1) der Photomaske, über der Belichtungslicht einzustrahlen ist, in eine Vielzahl von virtuellen Regionen (2, 3) geteilt ist, die eine gleichförmige Größe haben, Aperturflächenverhältnisse der Vielzahl von virtuellen Regionen gleichförmig sind, wobei das Aperturflachenverhältnis definiert ist als das Verhältnis der Fläche einer virtuellen Region, die Licht durchlässt, zu der Fläche derselben, die kein Licht durchlässt.

2. Photomaske nach Anspruch 1, bei der dann, falls eine virtuellen Region (2, 3) ein Gesamt-Aperturflächenverhältnis aufweist, worin jedes Muster enthalten ist, außer dem Untermuster, das niedriger als jenes einer anderen virtuellen Region (2, 3) ist, die Reduzierung des Aperturfläehcnverhältnisses, die durch die Bildung des Untermusters in der genannten virtuellen Region (2, 3) bewirkt wird, niedriger als die Reduzierung des Aperturflächenverhältnisses ist, die durch die Bildung des Untermusters in der anderen virtuellen Region (2, 3) bewirkt wird.

3. Photomaske nach Anspruch 1 oder 2,
bei der Teilungen der Untermuster im Wesentlichen gleichförmig sind und jene virtuellen Regionen (2, 3), die ein niedrigeres Gesamt-Aperturflächenverhältnis aufweisen, worin jedes Muster enthalten ist, außer dem Untermuster, Untermuster haben, die über die Vielzahl von virtuelle Regionen (2, 3) in der Größe kleiner sind.

4. Photomaske nach Anspruch 1 oder 2,
bei der die Größen der Untermuster im Wesentlichen gleichförmig sind und jene virtuellen Regionen (2, 3), die ein niedrigeres Gesamt-Aperturflächenverhältnis aufweisen, worin jedes Muster enthalten ist, außer dem Untermuster, Untermuster haben, die über die Vielzahl von virtuellen Regionen (2, 3) spärlicher gebildet sind.

5. Photomaske nach Anspruch 1 oder 2,
bei der jene virtuellen Regionen (2, 3), die ein niedrigeres Gesamt-Aperturflächenverhältnis aufweisen, worin jedes Muster enthalten ist, außer den Untermustern, Untermuster haben, die über die Vielzahl von virtuellen Regionen (2, 3) in der Größe kleiner sind und spärlicher gebildet sind.

6. Photomaske nach Anspruch 1 oder 2, bei der die virtuelle Region (2, 3) eine Region eines Rechtecks ist, das jeweilige Seiten von 0,5 µm bis 5 µm hat.

7. Photomaske nach Anspruch 1 oder 2,
bei der ein Muster zum Polieren gebildet ist, welches Muster zum Polieren größer als eine minimale Größe ist, die durch Belichtung auf den lichtempfindlichen Körper übertragbar ist, und in einem Bereich liegt, wo eine Beeinflussung einer Operation des Halbleiterbauelementes zulässig ist, wenn das Muster zum Polieren auf den lichtempfindlichen Körper übertragen ist.

8. Photomaske nach Anspruch 7, bei dem
das Umtermuster und das Muster zum Polieren entweder ein Positivtyp oder ein Nogativtyp sind, die sich voneinander unterscheiden, und
das Untermuster innerhalb des Musters zum Polieren gebildet ist.

9. Verfahren zum Konstruieren einer Photomaske zur Verwendung beim Belichten eines lichtempfindlichen Körpers auf einem Sobstrat, welches Konstruktionsverfahren die Schritte umfasst:
Bestimmen eines Hauptmusters, das auf den lichtempfindlichen Körper zu übertragen ist, auf der Basis einer Snhaltungsanordnung eines Halbleiterbauelementes, das herzustellen ist; und
Bestimmen einer Vielzahl von Untermustern, die zur Übertragung auf den lichtempfindlichen Körper selektiert werden können, welche Untermuster eine Größe haben, die kleiner als eine minimal Größe ist, die auf den lichtempfindlichen Körper durch Belichtung übertragbar ist;
**gekennzeichnet durch** Teilen einer Einstrahlungsregion der Photomaske, über der Bclichtungslicht einzustrahlen ist, in eine Vielzahl von virtuellen Regionen (2, 3), die eine gleichförmige Größe haben, und Berechnen von Aperturflächenverhältnissen für die Muster, die zu jener Zeit für jede von der Vielzahl von virtuellen Regionen (2, 3) bestimmt sind, wobei das Aperturflächenverhältnis definiert ist als das Verhältnis der Fläche einer virtuellen Region, die Licht durchlässt, zu der Fläche derselben, die kein Licht durchlässt;
bei dem die Aperturflächenverhältnisse der Vielzahl von virtuellen Regionen (2, 3) beim Schritt zum Bestimmen einer Vielzahl von Untermuster, gleichförmig gemacht werden.

10. Verfahren nach Anspruch 9, bei dem beim Schritt zum Bestimmen einer Vielzahl von Untermustern eine der virtuellen Regionen (2, 3), die ein Gesamt-Aperturflächenverhältnis aufweiset, worin jedes Muster enthalten ist, außer dem Untermuster, das niedriger als jenes einer anderen virLuellen Region (2, 3) ist, so vorgesehen wird, dass die Reduzierung des Aperturflächenverhältnisses, die durch die Bildung des Untermustcrs in der genannten virtuellen Region (2, 3) bewirkt wird, niedriger als die Reduzierung des Aperturflächenverhältnisses ist, die durch die Bildung des Untermuster, in der anderen virtuellen Region (2, 3) bewirkt wird.

11. Verfahren nach Anspruch 9 oder 10, bei dem beim Schritt zum Bestimmen einer Vielzahl von Untermustern Teilungen der Untermuster der Vielzahl von virtuellen Regionen (2, 3) im Wesentlichen gleichförmig sind und jene virtuellen Regionen (2, 3), die ein niedrigeres Gesamt-Aperturflachenverhältnis aufweisen, worin jedes Muster enthalten ist, außer dem Untermuster, Untermtaster haben, die in der Größe kleiner sind.

12. Verfahren nach Anspruch 9 oder 10, bei dem beim Schritt zum Bestimmen einer Vielzahl von Untermustern Größen der Untermuster, der Vielzahl von virtuellen Regionen (2, 3) im Wesentlichen gleichförmig sind und jene virtuellen Regionen (2, 3), die ein niedrigeres Gesamt-Aperturflächenverhältnis aufweisen, worin jedes Muster enthalten ist, außer dem Untermuster, Untermuster haben, die spärlicher angeordnet sind.

13. Verfahren nach Anspruch 9 oder 10, bei dem beim Schritt zum Bestimmen einer Vielzahl von Untermustern jene virtuellen Regionen (2, 3), die ein niedrigere Gesamt-Aperturflächenverhältnis aufweisen, worin jedes Muster enthalten ist, außer dem Untermuster, Untermuster haben, die in der Größe kleiner sind und spärliche angeordnet sind.

14. Verfahren nach Anspruch 9 oder 10, bei dem beim Schritt zum Bestimmen einer Vielzahl von Untermuster, die virtuelle Region (2, 3) als Rechteck vorgesehen wird, das jeweilige Seiten von 0,5 µm bis 5 µm hat.

15. Verfahren nach Anspruch 9 oder 10, ferner mit dem Schritt zum Bestimmen eines Musters zum Polieren, vor dem Schritt zum Berechnen des Gesamt-Aperturflächenverhältnisses, welches Muster zum Polieren größer als eine minimale Größe ist, die durch Belichtung auf den lichtempfindlichen Körper übertragbar ist, und in einem Bereich liegt, wo eine Beeinflussung einer Operation des Halbleiterbauelementes zulässig ist, wenn das genannte Muster auf den lichtempfindlichen Körper übertragen ist.

16. Verfahren nach Anspruch 9 oder 10, bei dem
das Untermuster und das Muster zum Polieren entweder ein Positivtyp oder ein Negativtyp sind, die sich voneinander unterscheiden, und
das Untermuster innerhalb des Musters zum Polieren gebildet wird.

17. Verfahren zum Herstellen eines Halbleiterbauelementes mit dem Schritt zum Belichten eines lichtempfindlichen Körpers, der auf einer Schicht gebildet ist, die unter Verwendung einer Photomaske nach Anspruch 1 oder 2 zu bearbeiten ist.

## Revendications

1. Photomasque destiné à être utilisé pour exposer un corps photosensible sur un substrat, le photomasque comprenant :
un motif principal qui doit être transféré sur ledit corps photosensible ; et
une pluralité de motifs secondaires, la taille desdits motifs secondaires étant inférieure à une taille minimum transférable sur ledit corps photosensible par exposition ;
**caractérisé en ce que**, lorsqu'une zone d'irradiation (1) du photomasque, sur laquelle la lumière d'exposition doit être irradiée, est sectionnée en une pluralité de zones virtuelles (2, 3) ayant une taille uniforme, les rapports de surface d'ouverture de ladite pluralité de zones virtuelles, qui sont définis comme le rapport entre la surface d'une zone virtuelle qui transmet de la lumière et la surface de celle-ci qui ne transmet pas de lumière, sont uniformes.

2. Photomasque selon la revendication 1, dans lequel, si une zone virtuelle (2, 3) présente un rapport de surface d'ouverture cumulé, comprenant chaque motif, à l'exception dudit motif secondaire, inférieur à celui d'une autre zone virtuelle (2, 3), la réduction du rapport de surface d'ouverture provoquée par la formation dudit motif secondaire dans ladite zone virtuelle (2, 3) est inférieure à la réduction du rapport de surface d'ouverture provoquée par la formation dudit motif secondaire dans ladite autre zone virtuelle (2, 3).

3. Photomasque selon la revendication 1 ou 2, dans lequel les pas desdits motifs secondaires sont sensiblement uniformes et lesdites zones virtuelles (2, 3) présentant un rapport de surface d'ouverture cumulé inférieur, comprenant chaque motif à l'exception dudit motif secondaire, possèdent des motifs secondaires dont la taille est inférieure à celle de la pluralité de zones virtuelles (2, 3).

4. Photomasque selon la revendication 1 ou 2, dans lequel les tailles desdits motifs secondaires sont sensiblement uniformes et lesdites zones virtuelles (2, 3) présentant un rapport de surface d'ouverture cumulé inférieur, comprenant chaque motif à l'exception dudit motif secondaire, possèdent des motifs secondaires qui sont formés de manière plus éparse sur la pluralité de zones virtuelles (2, 3).

5. Photomasque selon la revendication 1 ou 2, dans lequel lesdites zones virtuelles (2, 3) présentant un rapport de surface d'ouverture cumulé inférieur, comprenant chaque motif à l'exception desdits motifs secondaires, possèdent des motifs secondaires de plus petite taille et formés de manière plus éparse sur la pluralité de zones virtuelles (2, 3).

6. Photomasque selon la revendication 1 ou 2, dans lequel ladite zone virtuelle (2 ,3) est une zone rectangulaire qui possède des côtés respectifs de 0,5 µm à 5 µm.

7. Photomasque selon la revendication 1 ou 2, dans lequel un motif de polissage est formé, ledit motif de polissage étant plus grand qu'une taille minimum transférable sur ledit corps photosensible par exposition, et pouvant raisonnablement affecter le fonctionnement dudit dispositif à semi-conducteurs lorsque ledit motif de polissage est transféré sur ledit corps photosensible.

8. Photomasque selon la revendication 7, dans lequel ledit motif secondaire et ledit motif de polissage sont soit de type positif, soit de type négatif, et différents l'un de l'autre, et
ledit motif secondaire est formé à l'intérieur dudit motif de polissage.

9. Procédé de conception d'un photomasque destiné à être utilisé pour exposer un corps photosensible sur un substrat, ledit procédé de conception comprenant les étapes consistant à :
déterminer un motif principal qui doit être transféré sur ledit corps photosensible, sur la base de circuits d'un dispositif à semi-conducteurs à fabriquer ; et
déterminer une pluralité de motifs secondaires qui peuvent être choisis afin d'être transférés sur ledit corps photosensible, lesdits motifs secondaires ayant une taille inférieure à une taille minimum transférable sur ledit corps photosensible par exposition ;
**caractérisé par** le sectionnement d'une zone d'irradiation du photomasque, sur laquelle la lumière d'exposition doit être irradiée, en une pluralité de zones virtuelles (2, 3) ayant une taille uniforme, et le calcul des rapports de surface d'ouverture pour les motifs déterminés à ce moment pour chacune de ladite pluralité de zones virtuelles (2, 3), lesdits rapports de surface d'ouverture étant définis comme le rapport entre la surface d'une zone virtuelle qui transmet la lumière et la surface de celle-ci qui ne transmet pas la lumière ;
dans lequel, à ladite étape de détermination d'une pluralité de motifs secondaires, les rapports de surface d'ouverture de ladite pluralité de zones virtuelles (2, 3) sont rendus uniformes.

10. Procédé selon la revendication 9, dans lequel, à ladite étape de détermination d'une pluralité de motifs secondaires, l'une desdites zones virtuelles (2, 3) présentant un rapport de surface d'ouverture cumulé, comprenant chaque motif à l'exception dudit motif secondaire, inférieur à celui d'une autre zone virtuelle (2, 3) est tel que la réduction du rapport de surface d'ouverture provoquée par la formation dudit motif secondaire dans ladite zone virtuelle (2, 3) est inférieure à la réduction du rapport de surface d'ouverture provoquée par la formation dudit motif secondaire dans ladite autre zone virtuelle (2, 3).

11. Procédé selon la revendication 9 ou 10, dans lequel, à ladite étape de détermination d'une pluralité de motifs secondaires, les pas desdits motifs secondaires de la pluralité de zones virtuelles (2, 3) sont sensiblement uniformes, et les zones virtuelles (2, 3) présentant un rapport de surface d'ouverture cumulé inférieur, comprenant chaque motif à l'exception dudit motif secondaire, possèdent des motifs secondaires de taille plus petite.

12. Procédé selon la revendication 9 ou 10, dans lequel, à ladite étape de détermination d'une pluralité de motifs secondaires, les tailles desdits motifs secondaires de la pluralité de zones virtuelles (2, 3) sont sensiblement uniformes, et les zones virtuelles (2, 3) présentant un rapport de surface d'ouverture cumulé inférieur, comprenant chaque motif à l'exception dudit motif secondaire, possèdent des motifs secondaires disposés de manière plus éparse.

13. Procédé selon la revendication 9 ou 10, dans lequel, à ladite étape de détermination d'une pluralité de motifs secondaires, les zones virtuelles (2, 3) présentant un rapport de surface d'ouverture cumulé inférieur, comprenant chaque motif à l'exception dudit motif secondaire, possèdent des motifs secondaires de taille plus petite et disposés de manière plus éparse.

14. Procédé selon la revendication 9 ou 10, dans lequel, à ladite étape de détermination d'une pluralité de motifs secondaires, ladite zone virtuelle (2, 3) est un rectangle ayant des côtés respectifs de 0,5 µm à 5 µm.

15. Procédé selon la revendication 9 ou 10, comprenant en outre l'étape de détermination d'un motif de polissage, avant ladite étape de calcul du rapport de surface d'ouverture cumulé, ledit motif de polissage étant supérieur à une taille minimum transférable sur ledit corps photosensible par exposition, et pouvant raisonnablement affecter le fonctionnement dudit dispositif à semi-conducteurs lorsque ledit motif est transféré sur ledit corps photosensible.

16. Procédé selon la revendication 9 ou 10, dans lequel ledit motif secondaire et ledit motif de polissage sont soit de type positif, soit de type négatif, et sont différents l'un de l'autre, et
ledit motif secondaire est formé à l'intérieur dudit motif de polissage.

17. Procédé de fabrication de dispositif à semi-conducteurs comprenant l'étape d'exposition d'un corps photosensible formé sur une couche à traiter à l'aide d'un photomasque selon la revendication 1 ou 2.
